(19) Europäisches Patentamt
European Patent Office
Office européen des brevets

(11) **EP 0 987 656 B1**

(12) **EUROPEAN PATENT SPECIFICATION**

(45) Date of publication and mention
of the grant of the patent:
**10.11.2010   Bulletin 2010/45**

(51) Int Cl.:
*H04N 1/41* (2006.01)     *G06T 9/00* (2006.01)

(21) Application number: **99402225.9**

(22) Date of filing: **10.09.1999**

(54) **Method of graphics data compression**

Verfahren für Komprimierung von Grafikdaten

Méthode de compression de données graphiques

(84) Designated Contracting States:
**DE ES FR GB IT PT**

(30) Priority:  **17.09.1998   FR 9811627**

(43) Date of publication of application:
**22.03.2000   Bulletin 2000/12**

(73) Proprietor: **THOMSON multimedia**
**92100 Boulogne Billancourt (FR)**

(72) Inventor: **Bou Sleiman, Elias**
**92100 Boulogne Billancourt (FR)**

(74) Representative: **Ruellan-Lemonnier, Brigitte**
**Technicolor**
**1-5 rue Jeanne d'Arc**
**92130 Issy-les-Moulineaux (FR)**

(56) References cited:
EP-A- 0 680 030     EP-A- 0 720 347
US-A- 5 727 090     US-A- 5 740 345

## EP 0 987 656 B1

**Description**

The invention relates to a method of real-time coding and decoding of graphics data and a real-time graphics coder/decoder (codec). It applies more particularly to the coding/decoding of display data for screens, better known by the expression On Screen Display or OSD. This type of display is employed in video decoders, TV sets, video recorders and, in general, in all types of video apparatus.

The OSD display is used in identifying TV stations, in menus for setting up an appliance and in electronic guide menus for programmes (Programme Guide), but also in more complex applications such as the visual display of a background of a weather map. It may involve only the visual display of these data on the screen, of overlays or of superimpositions with the video images.

The data relating to this OSD display may be resident data, that is to say data held permanently in memories of the video apparatus using this type of display, or it may take the form of information installed when the hardware is manufactured, or even downloaded information. These data may also be transmitted over distance with the video data stream. This involves digital decoders, for example. In the case of video digital decoders of the MPEG type, an acronym for Motion Picture Expert Group, which process coded video data streams (video bitstreams) according to this MPEG standard, the video images are received in compressed form, particularly exploiting the spatial and temporal redundancy of the video sequences by virtue of movement estimation and of the discrete cosine transform. The OSD data are not related to this processing and are incorporated into the MPEG data stream in an uncompressed form and are stored in the decoder in this form so as to be made use of in real time.

The applications employing OSD display are becoming more and more complex, requiring ever larger amounts of data to be stored. The random-access memories RAM allocated to the OSD data, for reasons of cost, thus limit such applications or else cause the resolution of the images or patterns generated to be reduced, or else restrict the diversity of the menus and of the applications.

EP-A-0 680 030 and GB 2 277 179 describe data compression methods using dictionaries.

The object of the present invention is to remedy the abovementioned drawbacks.

Its subject is a method of compression of graphics data used for coding images in points mode (bitmap data), data consisting of a succession of addresses of a conversion table called symbols S, according to claim 1.

The invention also relates to a device for compressing graphics data according to claim 3.

The values to be compressed generally relate to data of bitmap type. These are addresses of the values of effective pixels, that is to say the luminance and/or chrominance values of the pixels visually displayed on the screen, which are stored in a palette of colours called palette. The images are then said to be palletized.

The two essential stages of the compression are therefore:

- variable-resolution coding of the length of every sequence of identical symbols, called run length. For each run length of identical successive symbols, of length L, the length L of each repetitive sequence detected is coded with a resolution which is variable as a function of its parent class which depends on the value of the run-length L. Coding by class makes it possible to attribute an optimal (minimal) code which is variable as a function of the parent class L. These classes are defined statistically, being based on a large population of graphics images.
- variable-binary-resolution coding of the symbol itself as a function of the order in which it occurs in an adaptive dictionary. This is achieved by storing the various symbols in a dictionary, as and when they are encountered, and coding the symbol on the basis of its actual address in the dictionary, which corresponds to a variable binary coding which increases with the number of colours encountered. By effective address should be understood the disregarding, for the address words, of non-activated high-order bits at zero.

One characteristic of the invention is of compressing this OSD information before storing it or else storing compressed information when resident data are involved. The compression algorithm used is simple, allowing real-time applications while giving a high compression ratio by virtue of the graphics coding used for the OSD display. This is because, on the one hand, the number of colours used during such coding is limited in itself in order to reduce the amount of data to be sent to the video recorder or to be stored in this decoder. Moreover, OSD displays generally exhibit areas of uniforms colour and repetitive patterns.

This algorithm therefore implements a combination of two types of coding: Run Length Coding (RLC) and variable-binary-resolution coding, both for the coding of the run lengths and for the coding of the symbols, that is to say of the addresses. By virtue of the invention, the random-access memory requirements of decoders, television receivers, video recorders, etc. are reduced. The cost of production of the hardware is reduced or, for a given cost, the applications relating to on-screen display (OSD) are of higher performance and/or the displays are of better quality.

The characteristics and advantages of the present invention will emerge better from the following description, given by way of example and by reference to the attached figures in which:

- Figure 1 represents a coder of bitmap data according to the invention,
- Figure 2 represents a coder by class for coding L,
- Figure 3 represents a symbol S coder,
- Figure 4 represents a flowchart of the method of coding bitmap data,
- Figure 5 shows an example of coding a stream of bitmap data,
- Figure 6 represents a decoder of bitmap coded data,
- Figure 7 represents a flowchart of the method of decoding bitmap coded data,
- Figure 8 shows an example of decoding a stream of bitmap coded data,
- Figure 9 represents a codec.

Numerous solutions exist these days as to the definition of OSD display, memory storage and use of the corresponding data. In general, OSD data are stored in the form of bitmaps, the widely-used expression meaning that the image is coded in points mode, that is to say on the basis of data (luminance, chrominance) describing the display (the image) in terms of pixels. Memories or registers of palettes of colours contain the various colours necessary for generating the symbols and graphics. Vector-type addressing of these colours is carried out by defining these colours not by their coding proper but by their address in a register of palettes. This register of palettes is also called colour-conversion table or Colour Look Up Table (CLUT).

The OSD information is generally distributed into regions or areas over an image, areas defined by coordinates. For each region, all the colours necessary for coding the pixels belonging to this region correspond to a palette of colours for this region. For each region, a bitmap allocates to each pixel of the region an address in the conversion table containing the luminance and chrominance information for these pixels, i.e. Y, U, V.

An example of storage of data received by an MPEG decoder in a random-access memory RAM of this decoder, according to the prior art, is described below. A first part of the RAM memory stores the stream of compressed MPEG data, a second part stores the display specific to the OSD display (OSD data) and a third part stores, for example, the video data of the decompressed images which will be necessary, for example, for re-ordering the images according to the MPEG standard.

In more detail, the memory storage of the OSD data is itself organized into three areas, a first area corresponding to the coordinates, a second area corresponding to the palette of colours and a third area corresponding to the bitmap data. In the first area of the memory allocated to the data of a defined OSD region are therefore stored the coordinates making it possible to define the place at which this region will be displayed on the screen. In the second area is stored the palette of colours necessary for representing this region, or CLUT conversion table, then, in the third area, for each pixel, the address in the conversion table (CLUT) corresponding to the coding of the pixel in terms of luminance and chrominance. These data in this third area are called bitmap data.

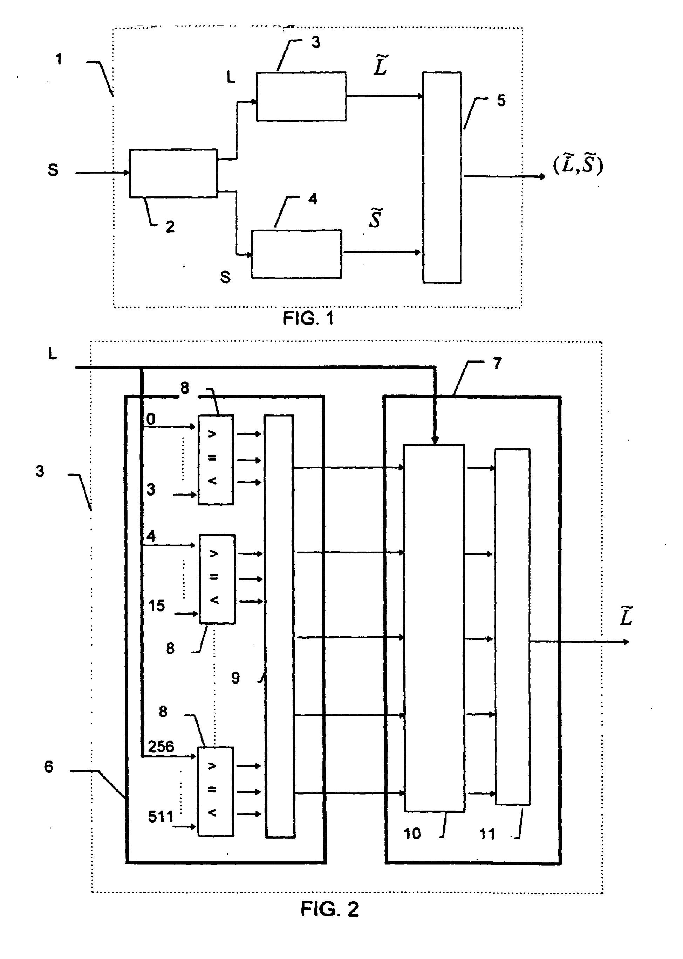

Figure 1 represents a coder 1 implementing the method of coding and compression of OSD data before storage in the RAM memories, for example the memories of an MPEG decoder. The OSD data in question are in fact the bitmap data. These bitmap data which, as described above, represent a succession of addresses which will be called symbols S are received as input of the coder 1 represented in dashes on the figure and which groups together circuits 2 to 5. These data are forwarded to a fixed-binary-resolution run-length coder 2. This coder supplies L information on a first output and S information on a second output, corresponding, for each region, to the number L of successive identical symbols S received as input. The output supplying the value L is sent to the input of a variable-binary-resolution coder by class 3 for coding this value L according to its parent class and the output supplying the value S is sent to the input of a variable-binary-resolution symbol coder 4. The outputs of the coders 3 and 4 supply respectively the coded values $\tilde{L}$ and $\tilde{S}$ of L and S and are linked to the inputs of a multiplexer 5 the output of which is the output of the coder 1.

The run-length coder 2 makes use of the method of coding by extent, better known by the title Run Length Coding or RLC. The principle of run-length coding consists in calculating the $L_k$ successive repetitions of a kth symbol $S_k$ and in replacing the sequence of repetitions of this symbol by the pair $V_k = (L_k, S_k)$. $L_k$ corresponds to the number of repetitions of the same symbol $S_k$. Each value of the pair is then coded separately using a special coding described below.

The coding of the value L is carried out as a function of its parent class, by the variable-binary-resolution coder by class 3. The coding principle employed by this coder is represented in Figure 2.

The information L to be coded coming from the run-length coder 2 is sent simultaneously to a class-detection circuit 6 and a variable-resolution coding circuit 7, the latter supplying the coded value of L, $\tilde{L}$, forwarded at the output of the coder 3.

The class-detection circuit consists, in our example, of 5 comparators 8 specific to each of the classes and receiving, in parallel, the information sent to the input of the coder 3, that is to say the value L (binary coded). Each comparator possesses three outputs corresponding respectively to an item of information at the input of the comparator below the limits, above the limits, or within the limits of the class (or interval) specific to this comparator. The outputs of the comparators are linked to a logic circuit 9 which groups together all the information originating from the comparators.

It possesses 5 outputs, which are also the outputs of the class-detection circuit 6, one output for each class, linked to five inputs of the variable-binary-resolution coding circuit 7. This coding circuit 7 consists of a transcoder 10 which receives, as input, the information corresponding to the value L (binary coded) and the five inputs indicating to which class this value belongs. The five outputs of the transcoder are linked to five inputs of a multiplexer 11 the output of which is the output of the coder 3. This output supplies a coded data stream $\tilde{L}$ corresponding to the input data stream L.

Before detailing the functioning of the circuit, we will describe the principle of variable-binary-resolution coding applied to the coding by class.

An area in which the value L can change is predefined on the basis of a value m such that $2^{2m+2}-1$ corresponds to the maximum possible value for coding L (maximum number of repetitions of the symbol). This area is broken down into m+1 intervals of values, each interval being bounded by the values $2^{2n}$ and $2^{2n+2}-1$, n varying from zero to m, one interval corresponding to one class. The principle of variable-binary-resolution coding by class consists in attributing a different resolution to each class. This binary resolution corresponds to the number of bits for coding L and thus depends on the class to which the value L belongs. It is a question, in fact, of taking into account, in the binary word L, only the "effective" coding bits, that is to say of ignoring the higher-order bits at zero, knowing that the non-transmission of these bits will correspond to the value zero. The coding is at low binary resolution for low values of L (n = 0, 1) and higher binary resolution for higher values (n = 2, 3, 4).

The various classes are identified by means of a particular code called identification code (the binary word for coding L, without taking account of the identification bits, will be represented by the symbol <L>). This code, which is a number of zeros sent before the coding word <L>, makes it possible therefore to identify the number of bits over which the value of the run-length L which immediately follows is coded. The words for coding L, represented by the symbol $\tilde{L}$ , therefore consist of two parts: a first part consisting of zero and making it possible to identify the class to which the value L belongs, and a second part <L> coding this value in base 2, with the minimum number of bits necessary for this coding.

An example is indicated in the table below for a value of m equal to 4, L then possibly having a maximum value of 1023:

| Class | coding by class (<L>) | identification code | resolution |
|---|---|---|---|
| 1-3 | 01-11 | - | 2 |
| 4-15 | 0100-1111 | 00 | 6 |
| 16-63 | 010000-111111 | 0000 | 10 |
| 64-255 | 01000000-1111111 | 000000 | 14 |
| 256-1023 | 0100000000-1111111111 | 00000000 | 18 |

The various coding classes $R_n = 2^{2n}, 2^{2n+2} -1$ are 1-3, 4-15, 16-63, 64-255, 256-1023. The "coding by class" column relates to the binary word <L> used for coding the L value representing the number of repetitions of the symbol S. The "identification code" column represents the bits for identifying the class. The "resolution" column indicates the number of bits necessary for coding L (this means the complete coding word $\tilde{L}$ grouping together the identification code and the coding word <L>).

For example a value L = 5 is coded by a 6-bit binary word (00.0101) whereas the value 49 is coded by a 10-bit binary word (0000.110001). The point is simply an indication of the juxtaposition of two different codes, the identification code followed by the <L> coding. As no L value corresponding to an <L> coding word beginning with two zeros exists (L is at least equal to 1), the identification of each of the parts, or more exactly the detection of the identification code, poses no problem in terms of the decoding.

Let us return to the functioning of the device represented in Figure 2.

Five comparators 8 corresponding to each of the five classes receive the L information in parallel on their input. Each comparator possesses three outputs and activates the first, second or third output according to whether the value received as input is less than, in the interval or greater than the interval corresponding to the class attributed to this comparator. This information is forwarded to the logic circuit 9 which activates the output corresponding to the class to which the L information belongs (this is obviously one embodiment example, and it could also be envisaged that the second output of each comparator be forwarded directly as output of the circuit 6). The class detection circuit then sends the variable-resolution coding circuit 7, on one of its five outputs, information corresponding to the class to which the value L belongs. This information is received by the circuit 10 for each L value received as input of the coding circuit 7. The transcoding carried out by the transcoding circuit 10 consists first of all in obtaining <L> by carrying out a truncation of the L-coding binary word received by the coder 3 and consisting at the outset of 10 bits for coding the values 1 to 1023. This truncation makes it possible to keep the 2, 4, 6, 8 or 10 lower-order bits of this coding word, according to whether the corresponding class information is respectively the 1st, 2nd, 3rd, 4th or 5th class. It then consists in adding the identification code before the binary word thus obtained, namely 0, 2, 4, 6 or 8 bits of zero value according to whether the corresponding class information is respectively the 1st, 2nd, 3rd, 4th or 5th class, giving $\tilde{L}$-coding words over 2, 6, 10, 14 or 18 bits. The transcoded binary words are sent to one of the inputs of the multiplexer 11 which supplies, at its output, the coding $\tilde{L}$ of the information L presented at the input. The coder 3 thus delivers, as output, a succession of $\tilde{L}$-coding words corresponding to the values of L received as input.

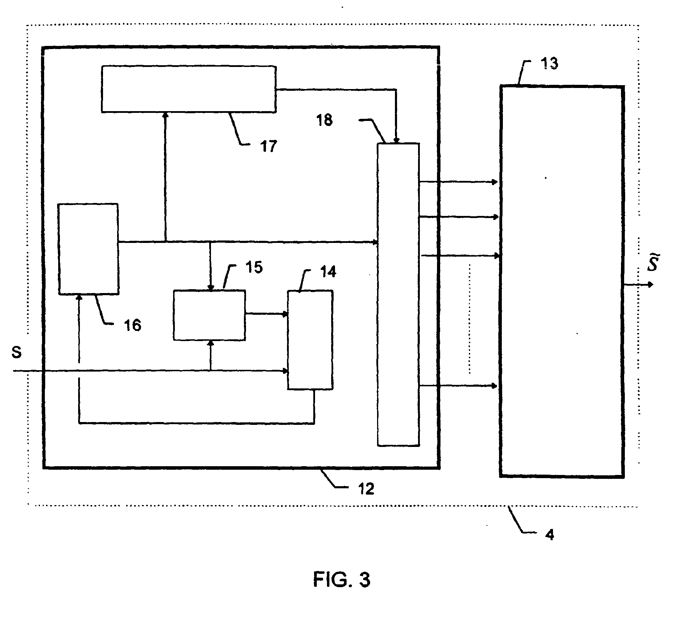

The coding of the value of the symbol S is carried out by the symbol coder 4. The principle for coding the value S is detailed in Figure 3.

The input of the coder 4 is linked to the input of a generation circuit of the dictionary 12 and receives the binary value of the symbol S. The 7 outputs of the circuit are linked to 7 inputs of a transcoding circuit 13 the output of which is the output of the symbol coder 4. The input of the coder 4 is linked to a first input of a comparator 14 and to a first input of a random-access memory called dictionary 15. The output of the comparator is linked to the clock input of an 8-bit counter 16. The output of this counter is linked to the address input of the random-access memory 15. It is also linked to a first input of a logic circuit 18 and to the input of a memory circuit 17, the output of which is linked to the second input of the logic circuit 18. This logic circuit possesses 7 outputs which are the outputs of the generation circuit of the dictionary 12. They are linked to 7 inputs of a transcoding circuit 13 which, at its output, supplies the coding of the symbol S, i.e. $\tilde{S}$.

The coding procedure is based essentially on the allocation of address in the dictionary. Hence, every time a symbol is received by the generation circuit of the dictionary 12, its binary value is compared with all the values stored in memory in the dictionary 12 by means of the comparator 14. In order to do this, a management circuit, not represented in the figure, controls the counter which scrolls the addresses as input to the dictionary 15 upon each arrival of a new symbol and each memory-stored value corresponding to these addresses is compared with the binary value of the symbol received. When the result of the comparison is negative, the 8-bit counter is incremented by comparison with the address of the last symbol stored in memory and the new symbol is stored in memory at this new address and is added to the dictionary.

The circuit 17 stores the highest address used for memory storage of a symbol in the dictionary and in particular the number t of "meaningful" bits over which this address is coded, that is to say the minimum number t such that $2^{t-1}$ is a greater than or equal to the binary value of the highest address, the minimum value of t being taken to be equal to 2 (the value t can therefore not reduce). It forwards the value of t to the circuit 18 so that the latter transmits only a number of bits, those of lower order, corresponding to the number t of meaningful bits coding the address of the last symbol stored in memory. One output of this logic circuit is allocated to each value of t, t lying between 2 and 8 for a possible memory storage of 256 values in the dictionary. The outputs are linked to the coding circuit 13 which carries out the following transcodings. The binary information received on the first input and thus over two bits is forwarded as it stands as output. When the binary information switches over onto the second input, indicating a coding of the address of the dictionary over 3 bits, a series of 10 bits at the value zero precedes the coding of this last binary word received over 3 bits. Every time the binary information switches over from one input to the other, indicating a coding over a higher number of bits, a series of 10 bits at the value zero is added in front of the first binary word received on this input.

The dictionary codes an address (a symbol) by a new address. It contains only the useful symbols, that is to say the addresses corresponding to the colours employed in the palette of colours for the OSD coding. For example, a region for which the symbol is coded over 8 bits has a palette of 256 colours. If only 64 colours from among the 256 are used in this region, the dictionary then contains 64 symbols.

The coding of each symbol is therefore done on the basis of its own address in the dictionary. It makes use of variable-binary-resolution coding, the information relating to this resolution being supplied by the addition of zeros. In the preceding example, there are 64 colours and the coded symbols have a binary resolution of 6 bits instead of 8 bits. By this operation alone, a saving of 25% is obtained. This is because many OSD regions use fewer than 256 colours, making this coding effective.

Let us give an example of operation below:

At the start of the cycle of sequential reading of the symbol, from the bitmap data, it is assumed that the OSD region has fewer than 4 different colours, the first symbol coded thus having a resolution of 2 bits. Each time a new, not already coded, symbol appears, that is to say a symbol not existing in the dictionary, it is stored in memory in the dictionary and the address is incremented. The first symbol is stored at address 0 and its code is therefore the value 00 whatever the value of this first symbol. When a new symbol is read, it is stored at address 01, its code is consequently 01. The fourth new symbol is dealt with in the same way and its code is 11. If the other values read are those stored in memory in the dictionary, their code will be the address lying between 00 and 11. The binary resolution is then 2 bits instead of the 8 bits over which the received symbols are coded. This is the case until a new symbol different from the four stored in memory in the dictionary is received. Then the resolution is incremented and changes to 3 bits for all the other symbols encountered. If a 6th symbol read already exists in the dictionary at address 01, its code will now be 001. The method continues until the dictionary contains more than 128 colours. From this stage, all the symbols have a resolution of 8 bits.

In order to carry out decoding of the symbol without ambiguity, a special code is therefore generated every time the resolution of the address of the dictionary is incremented. In the worst case, this code will be generated six times. The code is a sequence of 10 zeros. This is because only nine consecutive zeros (including eight for the identification code) are necessary for coding by run length L, for values above 255.

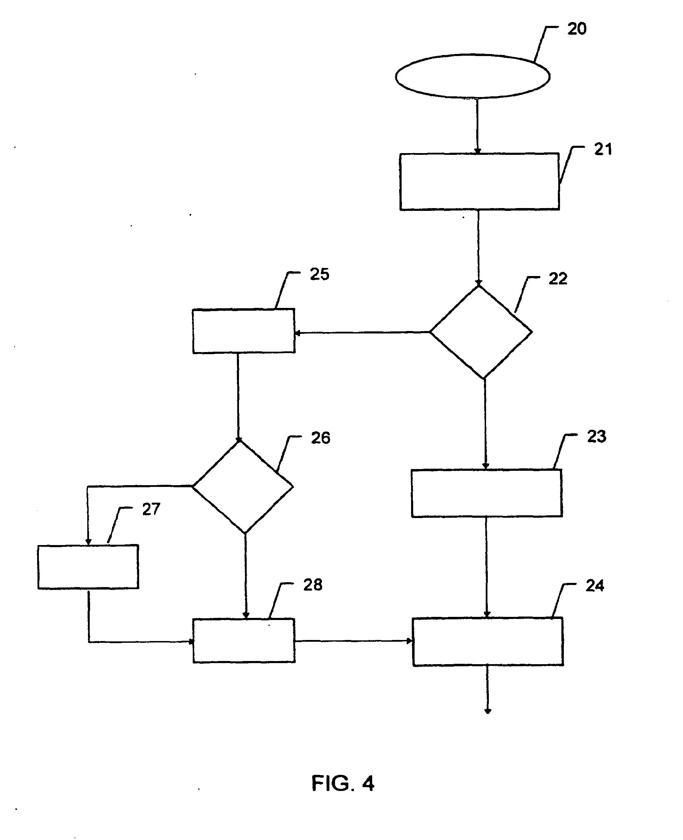

The algorithm for coding the symbol S is represented in Figure 4. Stage 20 consists in initializing the various parameters. A dictionary D is created with, at the outset, no data stored in memory.

Notations:

The symbol S is coded in the form c or z.c.

z is the identification code corresponding to 10 zeros,

c corresponds to the binary address at which the symbol is stored in memory (variable number of bits),

t is the number of bits used for coding c,

i is the index of the address of the dictionary D at which the symbol received as the input of the coder is stored in memory or recovered, and

n is the number of symbols (or colours) stored in memory in the dictionary.

At initialization, the value t is forced to 2, the index i is set to the address 1 (binary form 01).

When the first symbol $\alpha$ is received, its values stored in memory at address 1 of the dictionary.

$$D(1) = \alpha, \quad n = 1.$$

A new symbol is read at the following stage 21.

The stage 22 verifies whether the symbol already exists in the dictionary D. If yes, the stage 23 is run which will search for the value of the address i in the dictionary for which the word stored in memory corresponds to this symbol. The following stage 24 codes the symbol S with the binary value of i.

c = binary form of the address i.

If the symbol does not appear in the dictionary, stage 25 is run after stage 22. This stage increments the value n and the new symbol in stored in memory at address i = n. The following stage 26 verifies whether the new value n requires an additional coding bit.

Hence, if n is higher than the value $2^t$, t being the number of bits over which the address of the last symbol entered into dictionary is coded, stage 27 is carried out. The value t is incremented since the new address is coded over an additional bit. The binary resolution of c is incremented as a consequence, and an identification code z of 10 zeros precedes this value c. The following operations are carried out at stage 27:

generation of 10 zeros

t = t+1

binary resolution of c = t

Stage 28 succeeds stage 27, a stage in which the index i is given the value n, and the symbol $\alpha$ is stored in memory in the dictionary at address i.

i = n

D(i) = $\alpha$

If, at stage 26, it is noted that n is less than or equal to the value $2^t$, the following stage is stage 28 directly.

The stage succeeding stage 28 is stage 24 which therefore codes the value of the symbol by the binary value of the address i, preceded by 10 zeros if stage 27 has been implemented.

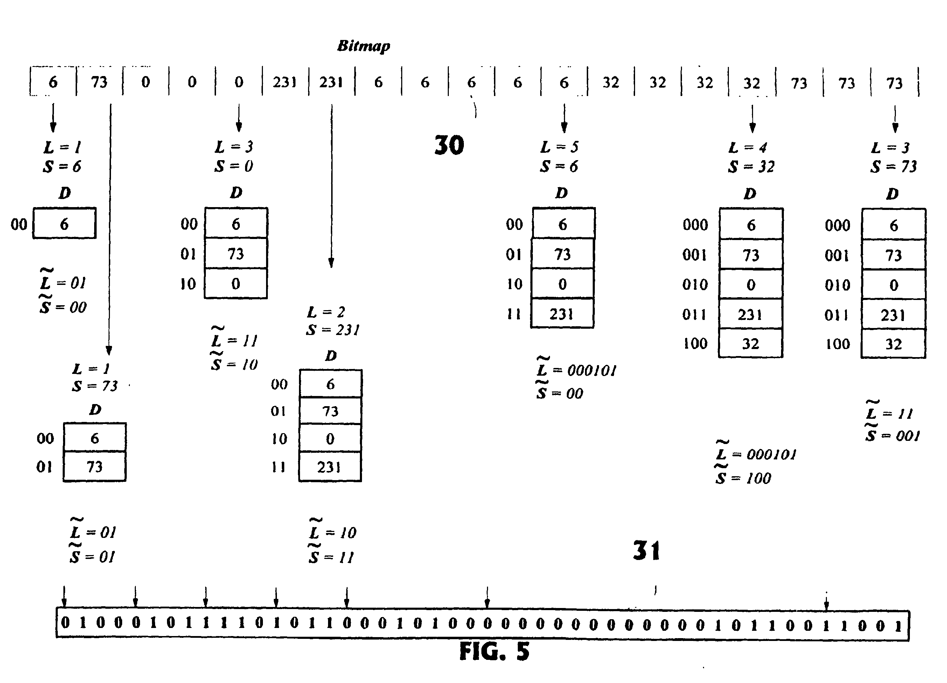

Figure 5 shows an example of coding on the basis of a bitmap data stream to be coded referenced 30 in the figure. L corresponds to the number of repetitions of the symbol and S corresponds to the value of the symbol.

$\tilde{S}$ is the binary word for coding the symbol S. In step with the coding of the bitmap data stream 30, the dictionary D fills up with the values of the symbols S and the memory-storage addresses are used for coding the symbols. The value 32 to be coded is the fifth value differing from the preceding ones, to be stored in the dictionary. On the basis of this value in the data stream, the binary coding word $\tilde{S}$ is therefore a word of at least 3 bits.

$\tilde{L}$ is the binary word for coding the value L. When the value of L is in the interval 1-3, the binary coding word $\tilde{L}$ is a 2-bit word. When the value of L is in the interval 4-15, the binary word for coding $\tilde{L}$ is a 6-bit word, the first two bits at zero to indicate the resolution of the coding, here over four bits.

The compressed data stream, referenced 31, is represented at the bottom of the figure. It corresponds to the succession of binary words $\tilde{L}$ and $\tilde{S}$ for each run length. Every time a new value of S is encountered in the data stream 30, a new L, S pair is coded. During the coding of the symbol with value 32, the binary resolution is incremented, the coding being done over 3 bits from this point on. Consequently, in the binary stream, a succession of 10 zeros is sent just before the coding of the corresponding L, S pair.

The decoding methods and circuits are described below.

The coded bitmap data, available at the output of the above-described OSD coder, are stored in a RAM memory of the video decoder, this memory being accessible by the OSD coder and the OSD decoder integrated into this video decoder as described later. The information stored in this memory is also the palette of colours, the coordinates defining the OSD areas as received by the video decoder, and also the dictionary constructed by the OSD coder and transferred into the RAM.

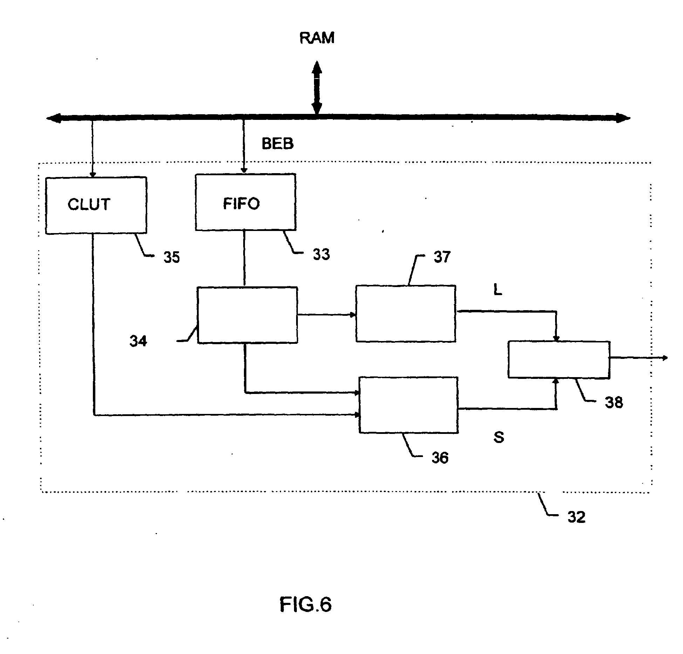

The decoding device 32 is represented in Figure 6.

The bus associated with the RAM memory of the video decoder is linked to a FIFO memory 33 and to a conversion table or memory 35 with a capacity of that of the above-described dictionary. The data at the output of the FIFO memory are sent to a field identification circuit 34. A first output of this circuit is sent to a run-length decoding circuit 37. A second output is linked to a first input of a symbol-extraction circuit 36. The memory 35, which also receives the information originating from the bus of the RAM memory, is linked to a second symbol-extraction circuit 36. The output of this latter circuit is linked to a second input of a circuit for generating the sequence of symbols 38. The output of the run-length decoding circuit 37 is linked to the first input of this circuit the output of which is the output of the decoder 32 represented in dashed line.

Hence, in the first place, the data, from the dictionary which is created at the coder upon coding the OSD data and which are stored in memory in the RAM in the form of a conversion table, are transferred, via the RAM memory bus, to the memory 32 so as to allow the decoder to make use of this information directly from this memory when calculating the symbols, that is to say without requiring access to the RAM memory.

The stream of point-mode-coded data (bitmap encoded bitstream or BEB) or coded bitmap data stored in memory in the RAM of the video decoder is sent to the FIFO memory. This memory, which has a regulating role, sends this data stream to the field-identification circuit 31. The circuit makes it possible to detect the sequences of zeros and to identify the coding fields.

The FIFO memory supplies a data stream consisting of three successive parts, according to the above-described compression protocol:

- a code field
- a run-length field
- a symbol field

These fields are of variable size. The code field which has a maximum size of 19 bits corresponds to the sequence of 10 zeros inserted in order to indicate the change of binary resolution of c (coding of S) followed by the code for identification of the class (8+1 zeros at most), indicating the binary resolution of <L> (coding of L). It thus makes it possible to determine the number of bits $n_i$ over which the value of L is coded and that, $n_s$, over which the address of the symbol is coded.

When the number of zeros in the code field is less than 10, the corresponding sequence of zeros, for example p zeros, relates only to the coding of L when this number is higher than 10, the first 10 zeros indicate that the binary resolution of c is incremented and the number p of remaining zeros of the sequence relates to the coding of L.

The value of p indicates the number of bits $n_i$ over which the run length is coded:

- if p is even, $n_i = p+2$
- if p is odd, $n_i = p$.

Once the values of $n_i$ and $n_s$ have been calculated, the symbol and run-length fields can be identified. The values corresponding to these fields can then be extracted.

Hence, the field-identification circuit 34 extracts the coded binary words from the stream corresponding to the coding of the run length in order to send them, on a first output, to the run-length decoding circuit 37 and the coded binary words of the stream corresponding to the coding of the symbol so as to send them on a second output to the symbol-extraction circuit 36. The run-length decoding circuit supplies the value L at its output. The symbol-extraction circuit will seek, on the basis of the address received from the field-identification circuit 34, the binary value of the symbol S stored in memory at this address in the memory 35. The circuit for generating the sequence of symbols 38 receives these L and S values and, on its output, gives the data stream corresponding to each value of S repeated L times.

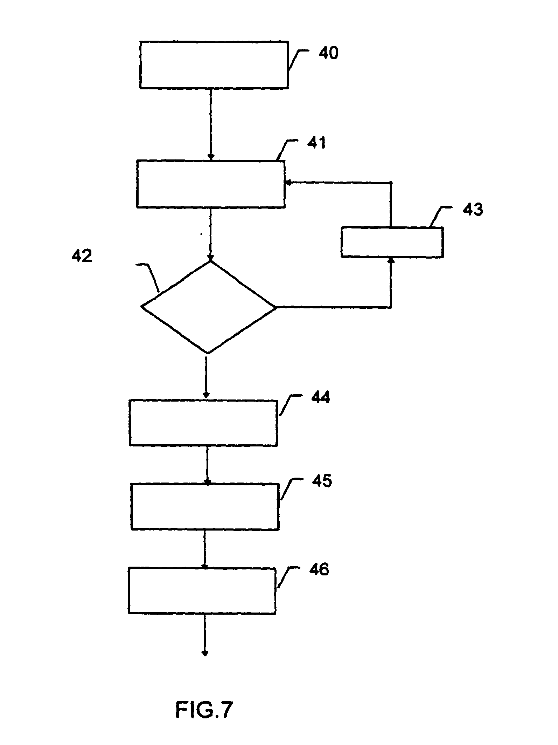

A decoding algorithm employed by this OSD decoder is represented in Figure 7.

A first stage 40 consists in reading and transferring the dictionary stored in the RAM memory of the video decoder to the memory 32 of the OSD decoder. The number of bits t for coding the symbol c is initialized at 2. The following stage 41 detects the sequence of zeros in the data stream sent by the FIFO memory and stores the number n of successive zeros in memory as long as this number is less than 10. As soon as this number is equal to 10 or as soon as the sequence of zeros is terminated, stage 42 is triggered which will distinguish these two cases:

- if n has reached the value 10, the following stage 43 increments the value of t used for coding c, then the stage 41 is followed and measures the new number of zeros n remaining after the first 10 zeros detected.
- if n is less than 10, stage 44 carries out run-length decoding. To do this, the number of zeros less than 10 or the number of zeros remaining if stage 43 has been gone through, a number previously called p, is used to determine the number of bits, successive to these zeros, to be taken into account for decoding L, this number being a function of the parity of p as indicated above.

After decoding the value of the run length L, the following stage 45 reads the number of bits t which follow the bits for coding the run length in order to determine the value c. Stage 46 will then search, in the memory 32, for the content of the address c which is the value of S.

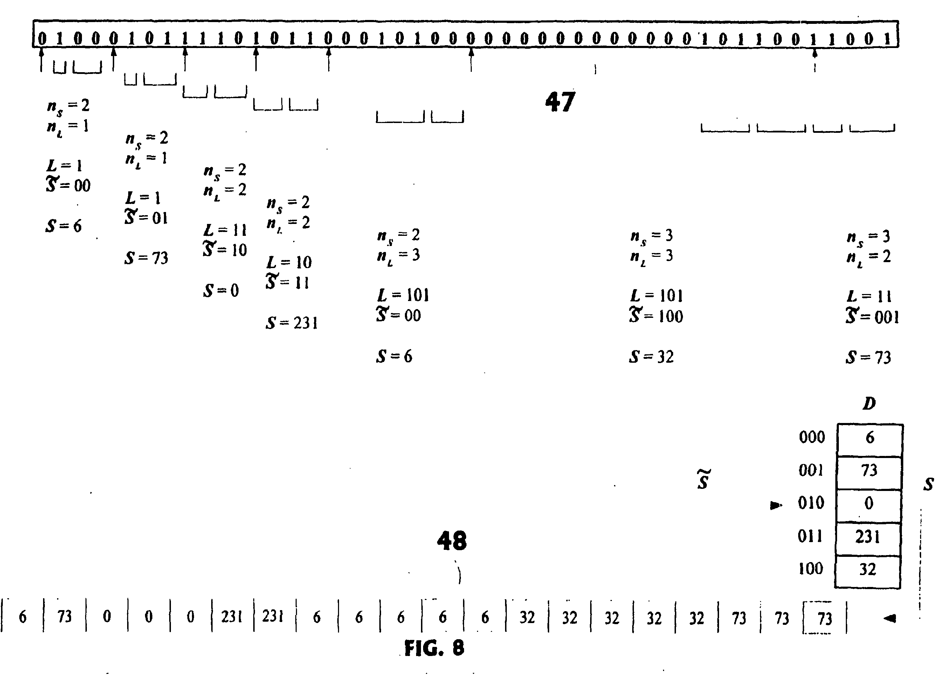

Figure 8 gives an example of decoding the data stream coded according to the invention, the data stream being referenced 47 in the figure.

At the outset, the value $n_s$ is initialized at 2. The code field corresponds to a single zero. Consequently, the value of $n_s$ remains equal to 2 and the value of $n_i$ is equal to 1 (p = 1). The run-length field contains the value 1 and the symbol field contains the value 00. Consequently, the value of L is equal to 1 and the value of S is the content of the dictionary at the address 00, i.e. 6. The following code field contains a single zero value, the lengths of the fields are therefore unchanged and the value of the symbol is found at address 01 of the dictionary. When a succession of zeros greater than or equal to 10 is encountered, the binary resolution for coding L changes. In our example a succession of 13 zeros appears. Hence, $n_s$ is incremented and S is read over 3 bits. The 3 zeros succeeding the 10 bits at zero indicate that the run-length field has a dimension of 3 bits. L is therefore coded by the 3 bits 101 and S by the following 3 bits 100. Hence, the value 32 found at address 100 is repeated 5 times.

The decoded data stream thus obtained is represented at the bottom of the figure under the reference 48. It corresponds to the succession of S binary words as received by the video decoder, that is to say before OSD coding and memory storage in the RAM.

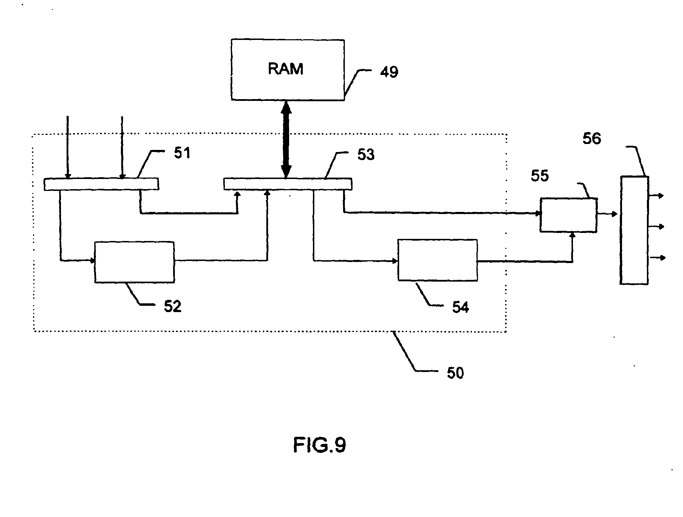

Figure 9 gives an example configuration of a codec consisting of an OSD coder and of an OSD decoder installed in a video decoder. The codec 50 represented in the figure in dashed line is linked to the RAM memory 49 of the video decoder via a memory bus.

The bitmap data, the coordinates of the OSD regions and the palette of colours, data received by the video decoder and relating to the OSD information, are sent to an input of the OSD codec, for example via an interface of a microcontroller of the video decoder, not represented in the figure. This input is linked to the input of a bus controller circuit 51 and this OSD information passes through the bus controller circuit 51 which directs the bitmap data, via a first output, to the OSD coder 52 and the palette of colours and the OSD coordinates, via a second output, to a first input of an input/output circuit 53. The output of the OSD coder 52 is linked to a second input of the input/output circuit 53. This circuit 53, by means of a bidirectional link, exchanges the data with the part outside the codec, in particular the RAM memory. The circuit 53 is linked, via a first output, to the OSD decoder 54 and, via a second output, to a first output of the codec 50. The output of the OSD decoder 54 is linked to a second output of the codec 50. The first output of this codec 50 is linked to a first input of a memory 55 of the video decoder. The second output of this codec 50 is linked to a second input of the memory 55. Finally, this memory 55 is linked to a circuit for generating luminance and chrominance signals 56 which supplies the Y, U, V information as output.

Hence the bitmap data received by the video decoder are sent to the OSD coder 52 via the bus controller 51 and the coded data at the output of this coder are sent, via the input/output circuit 53, to the RAM memory of the video decoder to be stored there. The other OSD data relating to the palette and the coordinates are also sent to the RAM memory via the bus controller and the input/output interface to be stored there in memory areas. The dictionary which was created in the coder is also transferred to the RAM memory. All this information, compressed in the case of the bitmap data, not compressed in the case of the palette, the coordinates and the content of the dictionary, are made use of by the OSD decoder 54. The latter, via the input/output interface 53, receives the coded bitmap data stream or BEB (bitmap encoded bitstream), as well as the dictionary. These data are decoded by this OSD decoder 54 which sends, as output to the CLUT memory 55 and for each pixel i, an address (now not coded) which is the address of the palette containing the colour corresponding to this pixel. This palette, stored in memory in the RAM, has been sent to this memory 55, prior to the decoding of the bitmap data, via the input/output interface 53. The digital luminance and chrominance data are sent as output from the memory 55 to the display circuit (Display Unit) 56 which additionally receives the video information.

A codec has been described in the case in which the OSD information are sent to the decoder. In the case in which this information is resident, the resident bitmap data may be bitmap data coded elsewhere, and it is not necessary to install an OSD coder in the video decoder. Then, only the OSD decoder is necessary in the video decoder.

## Claims

1. Method of compression of graphics data used for coding images in points mode (bitmap data), data consisting of a succession of addresses of a conversion table called symbols S, comprising the following stages:

   - storage of the various symbols in a dictionary (12) filled gradually during encoding,
   - coding of the symbol on the basis of its address in the dictionary (12),
   - variable-binary-resolution coding (13) of the address in the dictionary (12) serving for coding the symbol,

   **Characterized in that** it comprises the steps of

   - a run-length coding (2) of the symbols so as, for each range of identical successive symbols, to give a number L corresponding to the number of identical symbols, associated with the symbol S,
   - a variable-binary-resolution coding of L (3) as a function of the value of L.

   And **in that** the compression of the bitmap data produces a coded data stream including:

   - a variable-dimension code field consisting of a first field defining the dimensions of a run-length field and a second field defining the dimensions of a symbol field,
   - a run-length field for coding L, the dimensions of which corresponds to the binary resolution for coding L,
   - a symbol field for coding S, the dimensions of which correspond to the binary resolution for coding S.

   And **characterized in that**

   - the binary resolution for coding L is defined by the sending, before the bits for coding L, of zeros the number of which is a function of the number of bits over which this value L is coded.
   - the change of binary resolution to an increased binary resolution for coding the symbol on the basis of the address in the dictionary is defined by the sending, before the bits for coding the address, of a predefined number of zeros the value of which is higher than the maximum number of successive zeros used for coding L.

2. Method according to Claim 1. **characterized in that** the graphics data are OSD data and **in that** the images are palletized images.

3. Device for compressing graphics data used for coding images in points mode (bitmap data), data consisting of a succession of addresses of a conversion table called symbols S, comprising:

   - means of storage of the various symbols in a dictionary (12) filled gradually during encoding,
   - means for coding of the symbol on the basis of its address in the dictionary (12),
   - means for variable-binary-resolution coding (13) of the address in the dictionary (12) serving for coding the symbol,

   **Characterized in that** it comprises

   - a run-length coder (2) for coding the symbols so as, for each range of identical successive symbols, to give a number L corresponding to the number of identical symbols, associated with the symbol S,
   - a variable-binary-resolution coder (3) for coding L as a function of the value of L.

   And **in that** the compression of the bitmap data produces a coded data stream including:

- a variable-dimension code field consisting of a first field defining the dimensions of a run-length field and a second field defining the dimensions of a symbol field,
- a run-length field for coding L, the dimensions of which corresponds to the binary resolution for coding L,
- a symbol field for coding S, the dimensions of which correspond to the binary resolution for coding S.

And **characterized in that**

- the binary resolution for coding L is defined by the sending, before the bits for coding L, of zeros the number of which is a function of the number of bits over which this value L is coded.
- the change of binary resolution to an increased binary resolution for coding the symbol on the basis of the address in the dictionary is defined by the sending, before the bits for coding the address, of a predefined number of zeros the value of which is higher than the maximum number of successive zeros used for coding L.

**Patentansprüche**

1. Verfahren für die Komprimierung von Graphikdaten, die für die Codierung von Bildern in einem Punktemodus (Bitmapdaten) verwendet werden, wobei die Daten aus einer Folge von Adressen einer Umsetzungstabelle bestehen, die Symbole S genannt werden, wobei das Verfahren die folgenden Schritte umfasst:

   - Speicherung der verschiedenen Symbole in einem Wörterbuch (12), das während der Codierung allmählich gefüllt wird,
   - Codierung des Symbols auf der Grundlage seiner Adresse in dem Wörterbuch (12),
   - Codierung (13) mit variabler binärer Auflösung der Adresse in dem zum Codieren des Symbols dienenden Wörterbuch (12),

   **dadurch gekennzeichnet, dass** es die folgenden Schritte umfasst:

   - eine Lauflängencodierung (2) der Symbole, sodass sich für jeden Bereich gleicher aufeinanderfolgender Symbole eine Zahl L ergibt, die der Anzahl gleicher Symbole entspricht, die dem Symbol S zugeordnet wird,
   - eine Codierung (3) von L mit variabler binärer Auflösung als Funktion des Werts von L,

   und dadurch, dass die Komprimierung der Bitmapdaten einen codierten Datenstrom erzeugt, der Folgendes enthält:

   - ein Feld für Code mit variabler Dimension, das aus einem ersten Feld, das die Dimensionen eines Lauflängenfelds definiert, und aus einem zweiten Feld, das die Dimensionen eines Symbolfelds definiert, besteht,
   - ein Lauflängenfeld für die Codierung L, dessen Dimensionen der binären Auflösung für die Codierung L entsprechen,
   - ein Symbolfeld für die Codierung S, dessen Dimensionen der binären Auflösung für die Codierung S entsprechen,

   und **dadurch gekennzeichnet, dass**

   - die binäre Auflösung für die Codierung L dadurch definiert wird, dass vor den Bits für die Codierung L Nullen gesendet werden, deren Anzahl eine Funktion der Anzahl der Bits ist, über die dieser Wert L codiert ist,
   - die Änderung der binären Auflösung in eine höhere binäre Auflösung für die Codierung des Symbols auf der Grundlage der Adresse in dem Wörterbuch dadurch definiert wird, dass vor den Bits für die Codierung der Adresse eine vorgegebene Anzahl von Nullen gesendet wird, deren Wert höher als die maximale Anzahl der für die Codierung L verwendeten aufeinanderfolgenden Nullen ist.

2. Verfahren nach Anspruch 1, **dadurch gekennzeichnet, dass** die Graphikdaten OSD-Daten sind und dass die Bilder palettierte Bilder (engl. palletized images) sind.

3. Vorrichtung für die Komprimierung von Graphikdaten, die für die Codierung von Bildern in einem Punktemodus (Bitmapdaten) verwendet werden, wobei die Daten aus einer Folge von Adressen einer Umsetzungstabelle bestehen, die Symbole S genannt werden, wobei die Vorrichtung umfasst:

   - Mittel zur Speicherung der verschiedenen Symbole in einem Wörterbuch (12), das während der Codierung allmählich gefüllt wird,
- Mittel für die Codierung des Symbols auf der Grundlage seiner Adresse in dem Wörterbuch (12),
- Mittel für die Codierung (13) der Adresse in dem zum Codieren des Symbols dienenden Wörterbuch (12), **dadurch gekennzeichnet, dass** sie umfasst:
- einen Lauflängencodierer (2) zum Codieren der Symbole, sodass sich für jeden Bereich gleicher aufeinanderfolgender Symbole eine Zahl L ergibt, die der Anzahl gleicher Symbole entspricht, die dem Symbol S zugeordnet wird,
- einen Codierer (3) mit variabler binärer Auflösung zum Codieren von L als Funktion des Werts von L,

und dadurch, dass die Komprimierung der Bitmapdaten einen codierten Datenstrom erzeugt, der Folgendes enthält:

- ein Feld für Code mit variabler Dimension, das aus einem ersten Feld, das die Dimensionen eines Lauflängenfelds definiert, und aus einem zweiten Feld, das die Dimensionen eines Symbolfelds definiert, besteht,
- ein Lauflängenfeld für die Codierung L, dessen Dimensionen der binären Auflösung für die Codierung L entsprechen,
- ein Symbolfeld für die Codierung S, dessen Dimensionen der binären Auflösung für die Codierung S entsprechen,

und **dadurch gekennzeichnet, dass**

- die binäre Auflösung für die Codierung L dadurch definiert wird, dass vor den Bits für die Codierung L Nullen gesendet werden, deren Anzahl eine Funktion der Anzahl der Bits ist, über die dieser Wert L codiert ist,
- die Änderung der binären Auflösung in eine höhere binäre Auflösung für die Codierung des Symbols auf der Grundlage der Adresse in dem Wörterbuch dadurch definiert wird, dass vor den Bits für die Codierung der Adresse eine vorgegebene Anzahl von Nullen gesendet wird, deren Wert höher als die maximale Anzahl der für die Codierung L verwendeten aufeinanderfolgenden Nullen ist.

## Revendications

1. Procédé de compression de données graphiques pour le codage d'images en mode points (données "bitmap"), données constituées d'une succession d'adresses d'une table de conversion appelées symboles S, **caractérisé en ce qu'**il comprend les étapes suivantes :

- un stockage des symboles différents dans un dictionnaire (12) rempli graduellement pendant le codage,
- un codage du symbole sur la base de son adresse dans le dictionnaire (12),
- un codage à résolution binaire variable (13) de l'adresse dans le dictionnaire (12) servant pour coder le symbole,

**Caractérisé en ce qu'**il comprend les étapes de :

- un codage par plage (2) des symboles pour donner, pour chaque plage de symboles successifs identiques, un nombre L correspondant au nombre de symboles identiques, associé au symbole S,
- un codage à résolution binaire variable de L (3) en fonction de la valeur de L.

Et **en ce que** la compression des données bitmap produit un flux de données codées comprenant :

- un champ de code de dimension variable constitué d'un premier champ définissant la dimension d'un champ longueur de plage et un deuxième champ définissant la dimension d'un champ symbole,
- un champ longueur de plage pour le codage de L dont la dimension correspond à la résolution binaire pour le codage de L,
- un champ symbole pour le codage de S dont les dimensions correspond à la résolution binaire pour le codage de S.

Et **caractérisé en ce que**

- la résolution binaire pour le codage de L est définie par la transmission, avant les bits de codage de L, de zéros dont le nombre est fonction du nombre de bits sur lequel est codée cette valeur L,
- le changement de résolution binaire pour une plus grande résolution binaire pour le codage du symbole à partir de l'adresse dans le dictionnaire est défini par la transmission, avant les bits de codage de l'adresse, d'un nombre prédéfini de zéros dont la valeur est supérieure au nombre maximum de zéros successifs utilisés pour le codage de L.

2. Procédé selon la revendication 1 **caractérisé en ce que** les données graphiques sont des données OSD et **en ce que** les images sont des images palettisées.

3. Dispositif de compression de données graphiques pour le codage d'images en mode points (données "bitmap"), données constituées d'une succession d'adresses d'une table de conversion appelées symboles S, comprenant :

   - des moyens de stockage des symboles différents dans un dictionnaire (12) rempli graduellement pendant le codage,
   - des moyens de codage du symbole sur la base de son adresse dans le dictionnaire (12),
   - des moyens de codage à résolution binaire variable (13) de l'adresse dans le dictionnaire (12) servant pour coder le symbole,

   **Caractérisé en ce qu'**il comprend:

   - un codeur par plage (2) pour coder les symboles pour donner, pour chaque plage de symboles successifs identiques, un nombre L correspondant au nombre de symboles identiques, associé au symbole S,
   - un codeur (3) à résolution binaire variable pour coder L en fonction de la valeur de L.

   Et **en ce que** la compression des données bitmap produit un flux de données codées comprenant :

   - un champ de code de dimension variable constitué d'un premier champ définissant la dimension d'un champ longueur de plage et un deuxième champ définissant la dimension d'un champ symbole,
   - un champ longueur de plage pour le codage de L dont la dimension correspond à la résolution binaire pour le codage de L,
   - un champ symbole pour le codage de S dont les dimensions correspond à la résolution binaire pour le codage de S.

   Et **caractérisé en ce que**

   - la résolution binaire pour le codage de L est définie par la transmission, avant les bits de codage de L, de zéros dont le nombre est fonction du nombre de bits sur lequel est codée cette valeur L,
   - le changement de résolution binaire pour une plus grande résolution binaire pour le codage du symbole à partir de l'adresse dans le dictionnaire est défini par la transmission, avant les bits de codage de l'adresse, d'un nombre prédéfini de zéros dont la valeur est supérieure au nombre maximum de zéros successifs utilisés pour le codage de L.

FIG. 1

FIG. 2

13

FIG. 3

FIG. 4

FIG. 5

RAM

BEB

FIG.6

FIG.7

EP 0 987 656 B1

0 1 0 0 0 1 0 1 1 1 1 0 1 0 1 1 0 0 0 1 0 1 0 0 0 0 0 0 0 0 0 0 0 0 0 0 0 0 1 0 1 1 0 0 1 1 0 0 1

**47**

$n_s = 2$
$n_L = 1$

$L = 1$
$\tilde{S} = 00$

$S = 6$

$n_s = 2$
$n_L = 1$

$L = 1$
$\tilde{S} = 01$

$S = 73$

$n_s = 2$
$n_L = 2$

$L = 11$
$\tilde{S} = 10$

$S = 0$

$n_s = 2$
$n_L = 2$

$L = 10$
$\tilde{S} = 11$

$S = 231$

$n_s = 2$
$n_L = 3$

$L = 101$
$\tilde{S} = 00$

$S = 6$

$n_s = 3$
$n_L = 3$

$L = 101$
$\tilde{S} = 100$

$S = 32$

$n_s = 3$
$n_L = 2$

$L = 11$
$\tilde{S} = 001$

$S = 73$

**48**

| $\tilde{S}$ | D |
|---|---|
| 000 | 6 |
| 001 | 73 |
| ► 010 | 0 |
| 011 | 231 |
| 100 | 32 |

$S$

| 6 | 73 | 0 | 0 | 0 | 231 | 231 | 6 | 6 | 6 | 6 | 6 | 32 | 32 | 32 | 32 | 32 | 73 | 73 | 73 | ◄

**FIG. 8**

RAM — 49

51

53

56

55

52

54

50

FIG.9

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0680030 A
- GB 2277179 A